# EUROPEAN PATENT APPLICATION

(11) **EP 2 996 165 A1**
(43) Date of publication of application: **16.03.2016**
(21) Application number: 14794590.1
(22) Date of filing: 01.05.2014
(51) Int. Cl.: H01L 33/50, H05K 1/03

(54) **CIRCUIT BOARD, OPTICAL SEMICONDUCTOR DEVICE AND MANUFACTURING METHOD FOR SAME**

(30) Priority: 09.05.2013 JP 2013099627
(71) Applicant: Nitto Denko Corporation, Ibaraki-shi, Osaka 567-8680 (JP)
(72) Inventor: FUJII, Hironaka, Ibaraki-shi Osaka 567-8680 (JP); NINOMIYA, Akito, Ibaraki-shi Osaka 567-8680 (JP)
(74) Representative: Hoffmann Eitle
(86) International application number: PCT/JP2014/062102
(87) International publication number: WO 2014/181757

(57) **Abstract**

A circuit board includes a phosphor-containing board for mounting an optical semiconductor element at one side thereof in a thickness direction and an electrode wire laminated at the one side in the thickness direction of the phosphor-containing board so as to be electrically connected to the optical semiconductor element.

## Description

### TECHNICAL FIELD

The present invention relates to a circuit board, an optical semiconductor device, and a producing method thereof, to be specific, to a method for producing an optical semiconductor device, a circuit board used therein, and an optical semiconductor device including the circuit board.

### BACKGROUND ART

A light semiconductor device includes a circuit board having an electrode laminated on the upper surface thereof, a light semiconductor element mounted on the circuit board so as to be electrically connected to the electrode, and a phosphor layer provided on the circuit board so as to cover the light semiconductor element. In the light semiconductor device, an electric current flows from the electrode of the circuit board to the light semiconductor element, the wavelength of light emitted from the light semiconductor element is converted by the phosphor layer, and the light having the wavelength converted is applied upward.

Meanwhile, to improve the downward light flux of the light semiconductor device, for example, a light-emitting device including a translucent ceramics base, an LED mounted thereon, and a third wavelength conversion material provided below the translucent ceramics base and containing yellow phosphor particles has been proposed (ref: for example, the following Patent Document 1).

In the light-emitting device described in Patent Document 1, of the light emitted from the LED, the wavelength of the light transmitting through the translucent ceramics base downward is converted by the third wavelength conversion material, and the light after wavelength conversion is applied downward.

### Citation List

### Patent Document

Patent Document 1: International Publication No. WO2012-090350

### SUMMARY OF THE INVENTION

### PROBLEM TO BE SOLVED BY THE INVENTION

There is a demand of easy structure of the light semiconductor device to reduce the production cost.

In the light-emitting device in Patent Document 1, however, in addition to the translucent ceramics base, the third wavelength conversion material is provided at the lower side thereof, so that the number of members is large and thus, the structure of the light semiconductor device is complicated and the method for producing the light semiconductor device is complicated. As a result, there is a disadvantage of not being capable of sufficiently satisfying the above-described demand.

An object of the present invention is to provide a circuit board, a light semiconductor device, and a producing method thereof in which the light semiconductor device having an improved light flux at the other side in a thickness direction can be produced in an easy structure at lower cost.

### MEANS FOR SOLVING THE PROBLEM

To achieve the above-described object, a circuit board of the present invention includes a phosphor-containing board for mounting an optical semiconductor element at one side thereof in a thickness direction and an electrode wire laminated at the one side in the thickness direction of the phosphor-containing board so as to be electrically connected to the optical semiconductor element.

The circuit board includes the phosphor-containing board, so that the wavelength of light emitted toward the other side in the thickness direction can be converted by the phosphor-containing board without separately providing a phosphor layer at the other surface of the phosphor-containing board. Thus, while the light flux at the other side in the thickness direction of the optical semiconductor device is improved, the number of members of the optical semiconductor device is reduced and the structure of the optical semiconductor device can be simplified. As a result, the number of producing steps of the optical semiconductor device is reduced and the producing method is simplified, so that the productivity of the optical semiconductor device can be improved and the production cost can be reduced.

In the circuit board of the present invention, it is preferable that the phosphor-containing board has light-transmitting properties.

According to the circuit board, the phosphor-containing board has light-transmitting properties, so that the wavelength of the light emitted from the optical semiconductor element toward the other side in the thickness direction is converted, while transmitting through the phosphor-containing board. Thus, a reduction in light emission amount at the other side in the thickness direction can be prevented.

In the circuit board of the present invention, it is preferable that the phosphor-containing board is prepared from ceramics.

In the circuit board, the phosphor-containing board is prepared from the ceramics, so that it has excellent heat dissipation.

In the circuit board of the present invention, it is preferable that the phosphor-containing board is prepared from a phosphor resin composition in a C-stage state containing a phosphor and a curable resin.

In the circuit board, the phosphor-containing board is prepared from the phosphor resin composition in the C-stage state, so that it has excellent flexibility.

An optical semiconductor device of the present invention includes the above-described circuit board and an optical semiconductor element mounted at one side in a thickness direction of a phosphor-containing board of the circuit board so as to be electrically connected to an electrode wire.

In the optical semiconductor device, the circuit board includes the phosphor-containing board, so that the wavelength of the light emitted from the optical semiconductor element toward the other side in the thickness direction can be converted by the phosphor-containing board without providing a phosphor layer. Thus, the light flux at the other side in the thickness direction is excellent and the number of members is reduced, so that the structure of the optical semiconductor device can be simplified. As a result, the productivity of the optical semiconductor device can be improved.

In the optical semiconductor device of the present invention, it is preferable that at least any one of an encapsulating layer, a reflective layer, and a phosphor layer provided at the one side in the thickness direction of the phosphor-containing board is further included.

In the optical semiconductor device, the optical semiconductor element is encapsulated by the encapsulating layer, so that the reliability can be improved; the light emitted from the optical semiconductor element is reflected by the reflective layer, so that the luminous efficiency can be improved; and furthermore, the wavelength of the light emitted from the optical semiconductor element toward the one side in the thickness direction is converted by the phosphor layer, so that the light flux at the one side in the thickness direction can be improved.

A method for producing an optical semiconductor device of the present invention includes a preparing step of preparing the above-described circuit board and a mounting step of mounting an optical semiconductor element at one side in a thickness direction of a phosphor-containing board of the circuit board so as to be electrically connected to an electrode wire.

According to this method, the optical semiconductor element is mounted at the one side in the thickness direction of the phosphor-containing board of the circuit board so as to be electrically connected to the electrode wire, thereby producing the optical semiconductor device. Thus, the number of members of the optical semiconductor device is reduced and therefore, the number of producing steps of the optical semiconductor device is reduced and the producing method is simplified, so that the productivity of the optical semiconductor device can be improved and the production cost can be reduced.

### EFFECT OF THE INVENTION

In the circuit board of the present invention, the number of producing steps of the optical semiconductor device is reduced and the producing method is simplified, so that the productivity of the optical semiconductor device can be improved and the production cost can be reduced.

In the optical semiconductor device of the present invention, the number of producing steps of the optical semiconductor device is reduced and the producing method is simplified, so that the productivity of the optical semiconductor device can be improved and the production cost can be reduced.

In the method for producing an optical semiconductor device of the present invention, the number of producing steps of the optical semiconductor device is reduced and the producing method is simplified, so that the productivity of the optical semiconductor device can be improved and the production cost can be reduced.

### BRIEF DESCRIPTION OF THE DRAWINGS

[FIG. 1] FIGS. 1A to 1B show process drawings for illustrating a method for producing a first embodiment of a circuit board of the present invention:
   FIG. 1A illustrating a step of preparing a phosphor-containing board and
   FIG. 1B illustrating a step of laminating electrode wires on the phosphor-containing board.
[FIG. 2] FIGS. 2C to 2D show process drawings for illustrating a method for producing an LED device that is a first embodiment of an optical semiconductor device of the present invention by the circuit board in FIG. 1B:
   FIG. 2C illustrating a step of mounting an LED on the circuit board and
   FIG. 2D illustrating a step of encapsulating the LED by a phosphor encapsulating layer.
[FIG. 3] FIGS. 3A to 3C show process drawings for illustrating a method for producing an LED device that is a second embodiment of an optical semiconductor device of the present invention:
   FIG. 3A illustrating a step of preparing a circuit board,
   FIG. 3B illustrating a step of mounting LEDs on the circuit board, and
   FIG. 3C illustrating a step of encapsulating the plurality of LEDs by an encapsulating layer.
[FIG. 4] FIGS. 4A to 4C show process drawings for illustrating a method for producing an LED device that is a third embodiment of an optical semiconductor device of the present invention:
   FIG. 4A illustrating a step of preparing a circuit board,
   FIG. 4B illustrating a step of mounting LEDs on the circuit board, and
   FIG. 4C illustrating a step of encapsulating the plurality of LEDs by an encapsulating layer.
[FIG. 5] FIG. 5 shows a front sectional view of an LED device that is a fourth embodiment of an optical semiconductor device of the present invention.
[FIG. 6] FIG. 6 shows a perspective view of an LED device that is a fifth embodiment of an optical semiconductor device of the present invention.
[FIG. 7] FIG. 7 shows a perspective view of an LED device that is a sixth embodiment of an optical semiconductor device of the present invention.
[FIG. 8] FIGS. 8A to 8B show views for illustrating mounting of an LED on a circuit board in an LED device that is a seventh embodiment of an optical semiconductor device of the present invention:
   FIG. 8A illustrating a perspective view and
   FIG. 8B illustrating a front sectional view.

### DESCRIPTION OF EMBODIMENTS

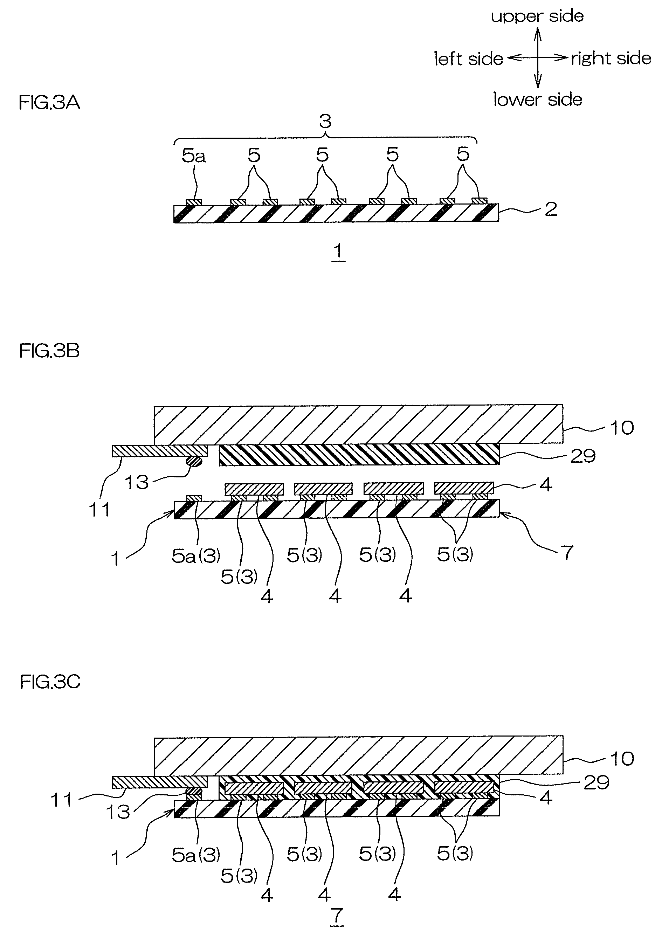

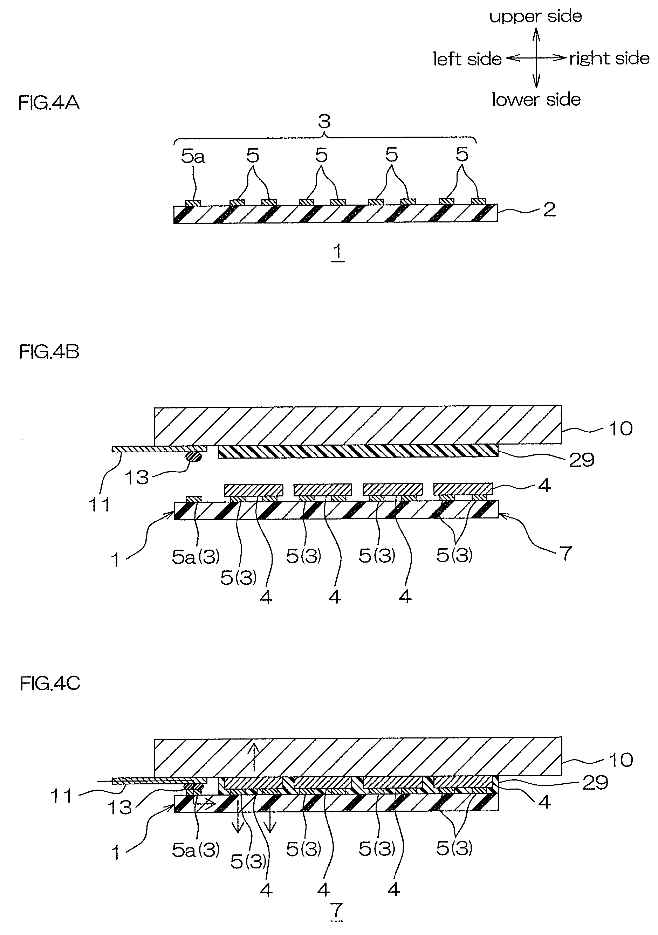

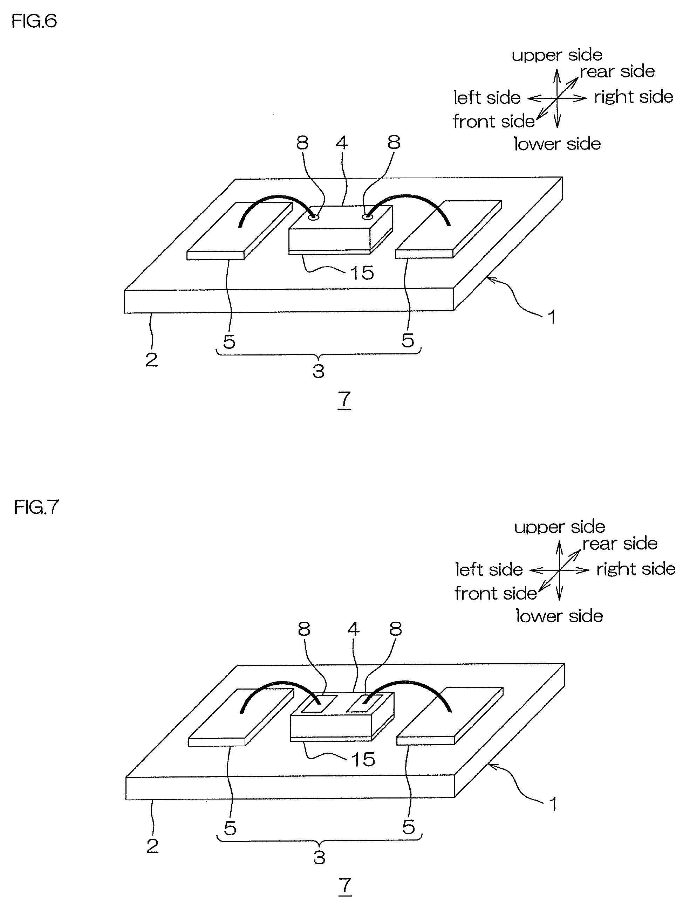

In FIGS. 3A to 3C and 4A to 4C, a terminal 8 (described later) is omitted and in FIGS. 6 and 7, a wire 6 (described later) and an adhesive layer 15 (described later) are omitted so as to clearly show the relative arrangement of an LED 4 (described later) and an electrode 5 (described later).

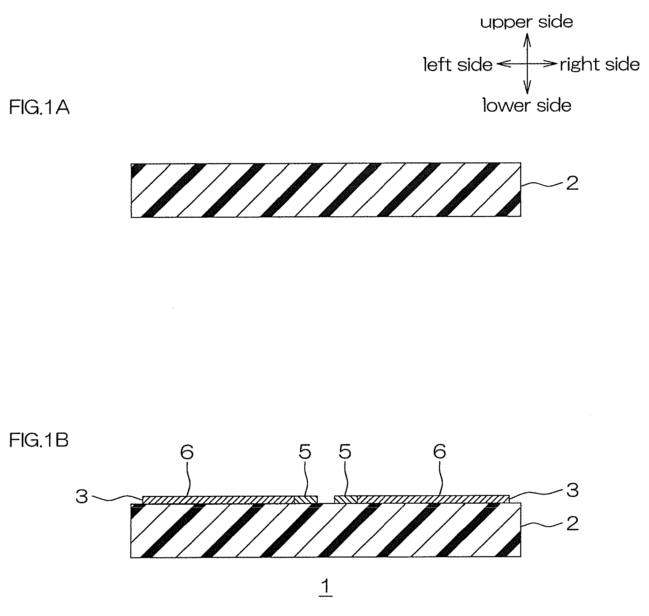

In FIG. 1A, the up-down direction of the paper surface is referred to as an "up-down direction" (first direction or thickness direction); the right-left direction of the paper surface is referred to as a "right-left direction" (second direction or direction orthogonal to the first direction); and the paper thickness direction is referred to as a "front-rear direction" (third direction or direction orthogonal to the first direction and the second direction). To be specific, directions are in conformity with direction arrows described in FIG. 1A. In each view other than FIG. 1A, directions are based on the directions in FIG. 1A.

### [First Embodiment]

As shown in FIG. 1B, a circuit board 1 includes a phosphor-containing board 2 and electrode wires 3 that are laminated on the upper surface (one surface in the thickness direction) of the phosphor-containing board 2.

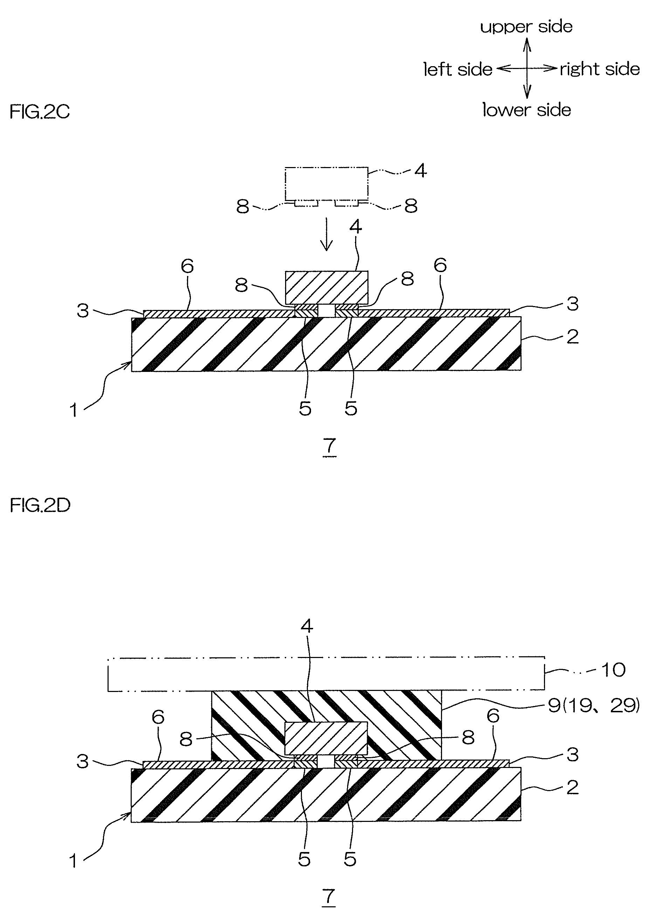

The phosphor-containing board 2 is a mounting board for mounting the LED 4 (ref: FIG. 2C) to be described later at the upper side thereof and is formed so as to correspond to the outer shape of the circuit board 1. The phosphor-containing board 2 is a phosphor board that contains a phosphor and is a light-transmitting board having light-transmitting properties. The phosphor-containing board 2 is also a wavelength conversion board that converts a part of blue light emitted from the LED 4 (ref: FIG. 2C) to be described later to yellow light and allows remaining blue light to transmit therethrough.

The phosphor-containing board 2 is formed into a generally rectangular plate shape or sheet shape extending in a plane direction (direction orthogonal to the thickness direction, that is, the right-left direction and the front-rear direction). The phosphor-containing board 2 is, for example, prepared from ceramics that is formed by sintering a phosphor or is prepared from a phosphor resin composition in a C-stage state containing a phosphor and a curable resin.

The phosphor is excited by absorbing a part or all of light at a wavelength of 350 to 480 nm as an exciting light and emits fluorescence that has a longer wavelength than that of the exciting light, for example, at 500 to 650 nm. To be specific, examples of the phosphor include a yellow phosphor that is capable of converting blue light into yellow light and a red phosphor that is capable of converting blue light into red light. Preferably, a yellow phosphor is used. An example of the phosphor includes a phosphor obtained by doping a metal atom such as cerium (Ce) or europium (Eu) into a composite metal oxide, a metal sulfide, or the like.

To be specific, examples of the yellow phosphor include garnet type phosphors having a garnet type crystal structure such as Y₃Al₅O₁₂:Ce (YAG (yttrium aluminum garnet):Ce), (Y, Gd)₃Al₅O₁₂:Ce, Tb₃Al₃O₁₂:Ce, Ca₃Sc₂Si₃O₁₂:Ce, and Lu₂CaMg₂(Si, Ge)₃O₁₂:Ce; silicate phosphors such as (Sr, Ba)₂SiO₄:Eu, Ca₃SiO₄Cl₂:Eu, Sr₃SiO₅:Eu, Li₂SrSiO₄:Eu, and Ca₃Si₂O₇:Eu; aluminate phosphors such as CaAl₁₂O₁₉:Mn and SrAl₂O₄:Eu; sulfide phosphors such as ZnS:Cu,Al, CaS:Eu, CaGa₂S₄:Eu, and SrGa₂S₄:Eu; and oxynitride phosphors such as CaSi₂O₂N₂:Eu, SrSi₂O₂N₂:Eu, BaSi₂O₂N₂:Eu, and Ca-α-SiAlON. Preferably, garnet type phosphors are used, or more preferably, Y₃Al₅O₁₂:Ce (YAG) is used.

Examples of the red phosphor include nitride phosphors such as CaAlSiN₃:Eu and CaSiN₂:Eu.

Examples of a shape of the phosphor include particle shapes such as a sphere shape, a plate shape, and a needle shape. Preferably, in view of fluidity, a sphere shape is used.

The phosphor has an average value of the maximum length (in the case of the sphere shape, the average particle size) of, for example, 0.1 µm or more, or preferably 1 µm or more, and, for example, 200 µm or less, or preferably 100 µm or less.

The phosphor has an absorption peak wavelength of, for example, 300 nm or more, or preferably 430 nm or more, and, for example, 550 nm or less, or preferably 470 nm or less.

These phosphors can be used alone or in combination of two or more.

To form the phosphor-containing board 2 from ceramics, for example, the phosphor-containing board 2 is obtained as phosphor ceramics by sintering a material for the phosphor (phosphor precursor material) to directly obtain the ceramics or by sintering a ceramic material having the above-described phosphor as a main component.

An additive can be added to the phosphor precursor material or the ceramic material at an appropriate proportion. Examples of the additive include a binder resin, a dispersant, a plasticizer, and a sintering assistant.

Meanwhile, to form the phosphor-containing board 2 from a phosphor resin composition in a C-stage state, first, the phosphor and a curable resin are blended, thereby preparing a phosphor resin composition.

The curable resin is a matrix that disperses the phosphor. Examples thereof include transparent resins such as a silicone resin, an epoxy resin, a polyimide resin, a phenol resin, a urea resin, a melamine resin, and an unsaturated polyester resin. Preferably, in view of durability, a silicone resin composition is used.

The silicone resin composition has in a molecule a main chain mainly composed of a siloxane bond (-Si-O-Si-) and a side chain composed of an organic group such as an alkyl group (e.g., methyl group and/or phenyl group, etc.) or an alkoxyl group (e.g., methoxy group) that is bonded to a silicon atom (Si) of the main chain.

To be specific, examples of the silicone resin composition include a dehydration condensation type silicone resin, an addition reaction type silicone resin, a peroxide curable silicone resin, a moisture curable silicone resin, and a curable silicone resin. Preferably, an addition reaction type silicone resin or the like is used.

The curable resin is prepared in an A-stage state and has a kinetic viscosity at 25°C of, for example, 10 to 30 mm²/s.

As the mixing ratio of the components, the mixing ratio of the phosphor with respect to the phosphor resin composition is, for example, 1 mass% or more, or preferably 5 mass% or more, and, for example, 50 mass% or less, or preferably 30 mass% or less. The mixing ratio of the phosphor with respect to 100 parts by mass of the resin is, for example, 1 part by mass or more, or preferably 5 parts by mass or more, and, for example, 100 parts by mass or less, or preferably 40 parts by mass or less.

The mixing ratio of the curable resin with respect to the phosphor resin composition is, for example, 50 mass% or more, or preferably 70 mass% or more, and, for example, 99 mass% or less, or preferably 95 mass% or less.

A filler and/or a solvent can be also blended in the phosphor resin composition as needed.

Examples of the filler include organic fine particles such as silicone particles (to be specific, including silicone rubber particles) and inorganic fine particles such as silica (e.g., fumed silica etc.), talc, alumina, aluminum nitride, and silicon nitride. The filler has an average value of the maximum length (in the case of the sphere shape, the average particle size) of, for example, 0.1 µm or more, or preferably 1 µm or more, and, for example, 200 µm or less, or preferably 100 µm or less. These fillers can be used alone or in combination of two or more. The mixing ratio of the filler with respect to 100 parts by mass of the curable resin is, for example, 0.1 parts by mass or more, or preferably 0.5 parts by mass or more, and, for example, 70 parts by mass or less, or preferably 50 parts by mass or less.

Examples of the solvent include aliphatic hydrocarbons such as hexane, aromatic hydrocarbons such as xylene, and siloxanes such as vinyl methyl cyclic siloxane and both terminal vinyl polydimethylsiloxane. The mixing proportion of the solvent is appropriately set.

The phosphor resin composition is prepared in an A-stage state by blending the phosphor and the curable resin (and, if necessary, the additive) at the above-described mixing proportion to be stirred and mixed.

Thereafter, the phosphor resin composition in the A-stage state is applied to a surface of a release sheet that is not shown to form a coated film. Thereafter, the coated film is thermally cured by heating and/or is subjected to active energy ray curing by application of an active energy ray (to be specific, ultraviolet ray), so that the phosphor-containing board 2 that is prepared from the phosphor resin composition in the C-stage state is produced.

The phosphor-containing board 2 has a thickness of, for example, 0.05 mm or more, or preferably 0.1 mm or more, and, for example, 3 mm or less, or preferably 1 mm or less. When the thickness of the phosphor-containing board 2 is the above-described upper limit or less, excellent light-transmitting properties of the phosphor-containing board 2 can be ensured. When the thickness thereof is the above-described lower limit or more, the strength of the phosphor-containing board 2 can be ensured.

The transmittance of the phosphor-containing board 2 in a thickness of 0.1 mm with respect to the light at a wavelength of 800 nm is, for example, 30% or more, preferably 40% or more, or more preferably 55% or more, and, for example, 75% or less. When the transmittance of the phosphor-containing board 2 is the above-described lower limit or more, the light-transmitting properties of the phosphor-containing board 2 can be improved. The transmittance of the phosphor-containing board 2 is obtained with a spectrophotometer, "V670" manufactured by JASCO Corporation.

When the phosphor-containing board 2 is prepared from a phosphor resin composition in a C-stage state, the phosphor-containing board 2 has a tensile elastic modulus at 25°C of, for example, 20 MPa or less, preferably 10 MPa or less, or more preferably 7.5 MPa or less, and, for example, 0.2 MPa or more. When the tensile elastic modulus of the phosphor-containing board 2 is the above-described upper limit or less, the flexibility of the phosphor-containing board 2 can be improved. The tensile elastic modulus of the phosphor-containing board 2 is obtained with a tensile testing machine, "AGS-J" manufactured by Shimadzu Corporation.

Meanwhile, when the phosphor-containing board 2 is prepared from ceramics, the phosphor-containing board 2 has thermal conductivity of, for example, 1 W/m·K or more, preferably 3 W/m·K or more, or more preferably 5 W/m·K or more, and, for example, 100 W/m·K or less. The thermal conductivity of the phosphor-containing board 2 is obtained with "LFA 447" manufactured by NETZSCH.

The electrode wires 3 are formed as a conductive pattern integrally including the electrodes 5 to be electrically connected to the terminals 8 of the LED 4 (ref: FIG. 2C) to be described later and the wires 6 to be continuous thereto. The electrode wires 3 are, for example, formed of a conductor such as gold, copper, silver, and nickel.

Two pieces (one pair) of electrodes 5 are provided with respect to one piece of LED 4 (ref: FIG. 2C). To be specific, the electrodes 5 are provided corresponding to two pieces of terminals 8 formed in one piece of LED 4.

Also, a protecting film that is not shown can be formed on the surfaces (the upper and side surfaces) of the electrode wires 3. The protecting film is, for example, in view of antioxidation and connectivity of wire bonding (described later), formed as a plating layer prepared from Ni and/or Au.

A size of the electrode wire 3 is appropriately set. To be specific, the electrode 5 has a maximum length of, for example, 0.03 mm or more, or preferably 0.05 mm or more, and, for example, 50 mm or less, or preferably 5 mm or less. An interval between the electrodes 5 that are adjacent to each other is, for example, 0.05 mm or more, or preferably 0.1 mm or more, and, for example, 3 mm or less, or preferably 1 mm or less. The wire 6 has a width of, for example, 20 µm or more, or preferably 30 µm or more, and, for example, 400 µm or less, or preferably 200 µm or less.

The electrode wire 3 has a thickness of, for example, 10 µm or more, or preferably 25 µm or more, and, for example, 200 µm or less, or preferably 100 µm or less. The protecting film that is not shown has a thickness of, for example, 100 nm or more, or preferably 300 nm or more, and, for example, 5 µm or less, or preferably 1 µm or less.

Next, a method for producing the circuit board 1 is described with reference to FIGS. 1A and 1B.

In this method, first, as shown in FIG. 1A, the phosphor-containing board 2 is prepared.

Next, in this method, as shown in FIG. 1B, the electrode wires 3 are laminated on the upper surface of the phosphor-containing board 2.

A method for laminating the electrode wires 3 on the upper surface of the phosphor-containing board 2 is not particularly limited and a known method is used.

To be specific, when the phosphor-containing board 2 is prepared from ceramics, for example, a method (heating and connecting method) is used in which a conductive sheet for forming the electrode wires 3 is brought into contact with the entire upper surface of the phosphor-containing board 2 to be subsequently heated, for example, at a temperature of 800 to 1200°C under an inert atmosphere such as Ar and N₂, so that a connecting board consisting of the phosphor-containing board 2 and the conductive sheet is formed. Thereafter, the conductive sheet is subjected to etching or the like, thereby forming the electrode wires 3.

When the phosphor-containing board 2 is prepared from ceramics, for example, a method (printing-heating and connecting method) is used in which a paste prepared by mixing a binder such as an organic compound and a solvent into a conductive powder is printed on the upper surface of the phosphor-containing board 2 in the above-described pattern to form a printing pattern; the conductive sheet is disposed along the printing pattern with a dispenser; and the obtained sheet is heated at the above-described temperature under an inert atmosphere or in vacuum to be connected. Furthermore, a Mo-Mn method, a copper sulfide method, a copper metallized method, and the like are used. Thereafter, the conductive sheet is subjected to etching or the like, thereby forming a conductive pattern.

As a method for laminating the electrode wires 3 on the upper surface of the phosphor-containing board 2, a printing method of printing the conductive paste containing the conductor in the above-described pattern is also used.

Or, a transfer method is also used in which the electrode wires 3 are separately formed on the upper surface of a supporting film, a release film, or the like in the above-described conductive pattern and then, the electrode wires 3 are transferred to the phosphor-containing board 2.

When the phosphor-containing board 2 is prepared from a phosphor resin composition in a C-stage state, preferably, a printing method and a transfer method are used because the phosphor resin composition has lower heat resistance than that of the ceramics.

Meanwhile, when the phosphor-containing board 2 is prepared from ceramics, in view of improvement of connecting strength of the phosphor-containing board 2 to the electrode wires 3, preferably, a connecting method and a printing-heating and connecting method are used.

In this manner, the circuit board 1 including the phosphor-containing board 2 and the electrode wires 3 is produced.

Next, a method for producing an LED device 7 using the circuit board 1 in FIG. 1B is described with reference to FIGS. 2C to 2D.

The method for producing the LED device 7 includes a preparing step of preparing the circuit board 1 and a mounting step of mounting the LED 4 as an optical semiconductor element on (at the one side in the thickness direction of) the phosphor-containing board 2 of the circuit board 1 so as to be electrically connected to the electrode wires 3.

In the preparing step, the circuit board 1 shown in FIG. 1B is prepared.

The mounting step is performed after the preparing step.

As shown by phantom lines in FIG. 2C, in the mounting step, first, the LED 4 is prepared.

In the LED 4, a flip-chip structure subjected to flip-chip mounting to be described later (so-called, flip chip) is used. The LED 4 is an optical semiconductor element that converts electrical energy to light energy and is, for example, formed into a generally rectangular shape in sectional view in which the thickness thereof is shorter than the length in the plane direction.

An example of the LED 4 includes a blue LED (light emitting diode element) that emits blue light. A size of the LED 4 is appropriately set in accordance with its intended use and purpose. To be specific, the LED 4 has a thickness of, for example, 10 µm or more and 1000 µm or less and a maximum length of, for example, 0.05 mm or more, or preferably 0.1 mm or more, and, for example, 5 mm or less, or preferably 2 mm or less.

The LED 4 has a light emission peak wavelength of, for example, 400 nm or more, or preferably 430 nm or more, and, for example, 500 nm or less, or preferably 470 nm or less.

The terminals 8 are formed at the lower portion of the LED 4. Two pieces of terminals 8 are formed at spaced intervals to each other in the right-left direction. Each of the terminals 8 is provided so as to correspond to each of the electrodes 5.

Next, as shown by an arrow in FIG. 2C, in the mounting step, the LED 4 is flip-chip mounted on the circuit board 1. To be specific, the LED 4 is mounted on the phosphor-containing board 2 and the terminals 8 are electrically connected to the electrodes 5.

To be more specific, as shown by the phantom lines in FIG. 2C, the LED 4 is disposed on the circuit board 1 so that the terminals 8 face downwardly. Next, as shown by solid lines in FIG. 2C, the terminals 8 are connected to the electrodes 5 by a connecting member such as solder (not shown) as needed.

In this manner, the LED device 7 including the circuit board 1 and the LED 4 that is mounted on the circuit board 1 is produced.

Thereafter, an encapsulating step is performed as needed.

As shown in FIG. 2D, in the encapsulating step, the LED 4 is encapsulated by a phosphor encapsulating layer 9 that is prepared from a phosphor encapsulating resin composition containing a phosphor and an encapsulating resin.

The phosphor encapsulating layer 9 is a phosphor layer that converts a part of blue light emitted from the LED 4 upwardly and laterally into yellow light and allows remaining blue light to transmit therethrough, and is also an encapsulating layer that encapsulates the LED 4.

An example of the phosphor includes the same phosphor as that illustrated in the phosphor-containing board 2. The phosphor content in the phosphor encapsulating layer 9 is the same as the mixing ratio illustrated in the phosphor-containing board 2.

An example of the encapsulating resin includes a transparent resin illustrated in the phosphor-containing board 2. To be specific, examples thereof include curable resins such as a two-step curable resin and a one-step curable resin.

The two-step curable resin is a curable resin which has a two-step reaction mechanism and in which in a first-step reaction, the resin is brought into a B-stage (semi-cured) state and in a second-step reaction, the resin is brought into a C-stage (completely cured) state. Meanwhile, the one-step curable resin is a thermosetting resin that has a one-step reaction mechanism and in which in a first step reaction, the resin is brought into a C-stage (completely cured) state.

The B-stage state is a state between an A-stage state in which the two-step curable resin is liquid and a C-stage state in which the two-step curable resin is completely cured. The B-stage state is a state in which curing and gelation slightly progress and the compressive elastic modulus is smaller than the elastic modulus in the C-stage state.

The mixing ratio of the encapsulating resin with respect to the phosphor encapsulating resin composition is, for example, 30 mass% or more, or preferably 50 mass% or more, and, for example, 99 mass% or less, or preferably 95 mass% or less.

The above-described filler and/or solvent can be also blended in the phosphor encapsulating resin composition at an appropriate proportion as needed.

To encapsulate the LED 4 by the phosphor encapsulating layer 9, for example, the phosphor encapsulating layer 9 in a sheet shape is formed in advance and next, the LED 4 is embedded by the phosphor encapsulating layer 9.

When the encapsulating resin is a two-step curable resin, first, the above-described components are blended and a phosphor encapsulating resin composition in an A-stage state is prepared. Next, the phosphor encapsulating resin composition in the A-stage state is applied to a surface of a release sheet that is not shown to form a coated film. Next, the coated film is brought into a B-stage state, so that the phosphor encapsulating layer 9 in the B-stage state is formed. Thereafter, the phosphor encapsulating layer 9 in the B-stage state is transferred to the circuit board 1 on which the LED 4 is mounted.

When the phosphor encapsulating layer 9 is transferred, the coated film is compressively bonded to the circuit board 1 or is subjected to thermal compression bonding as needed. In this manner, the LED 4 is embedded by the phosphor encapsulating layer 9 in the B-stage state and the LED 4 is encapsulated.

Or, the phosphor encapsulating resin composition in the A-stage state is applied to the circuit board 1 so as to cover the LED 4. In this manner, the LED 4 can be also encapsulated by the phosphor encapsulating layer 9.

Thereafter, the phosphor encapsulating layer 9 is brought into a C-stage state.

The phosphor encapsulating layer 9 covers the upper and side surfaces of the LED 4.

In this manner, the LED device 7 includes the circuit board 1, the LED 4 that is mounted on the circuit board 1, and the phosphor encapsulating layer 9 that encapsulates the LED 4 on the circuit board 1.

### [Function and Effect]

The circuit board 1 includes the phosphor-containing board 2, so that the wavelength of light emitted downwardly can be converted by the phosphor-containing board 2 without separately providing the phosphor layer described in Patent Document 1 on the lower surface of the phosphor-containing board 2. Thus, while the light flux downwardly of the LED device 7 is improved, the number of members of the LED device 7 is reduced and the structure thereof can be simplified. As a result, the number of producing steps of the LED device 7 is reduced and the producing method is simplified, so that the productivity thereof can be improved and the production cost can be reduced.

According to the circuit board 1, the phosphor-containing board 2 has light-transmitting properties, so that the wavelength of the light emitted from the LED 4 downwardly is converted, while transmitting through the phosphor-containing board 2. Thus, a reduction in light emission amount downwardly can be prevented.

In the circuit board 1, when the phosphor-containing board 2 is prepared from the ceramics, it has excellent heat dissipation.

In the circuit board 1, when the phosphor-containing board 2 is prepared from the phosphor resin composition in the C-stage state, it has excellent flexibility.

In the LED device 7, the circuit board 1 includes the phosphor-containing board 2, so that the wavelength of the light emitted from the LED 4 downwardly can be converted by the phosphor-containing board 2 without separately providing the phosphor layer described in Patent Document 1 on the lower side of the phosphor-containing board 2. Thus, the light flux downwardly is excellent and the number of members is reduced, so that the structure of the LED device 7 can be simplified. As a result, the productivity of the LED device 7 can be improved.

Furthermore, in the LED device 7, the LED 4 is encapsulated by the phosphor encapsulating layer 9, so that the reliability can be improved and the wavelength of the light emitted from the LED 4 upwardly and laterally is converted by the phosphor encapsulating layer 9, so that the light flux of the light can be improved. Accordingly, the LED device 7 can serve as a double-surface luminous type that emits light from both upper and lower surfaces thereof.

According to the above-described method, the LED 4 is mounted at the one side in the thickness direction of the phosphor-containing board 2 of the circuit board 1 so as to be electrically connected to the electrode wires 3, thereby producing the LED device 7. Thus, the number of members of the LED device 7 is reduced and therefore, the number of producing steps of the LED device 7 is reduced and the producing method is simplified, so that the productivity of the LED device 7 can be improved and the production cost can be reduced.

### <Modified Example>

In each of the figures subsequent to FIG. 3A, the same reference numerals are provided for members corresponding to each of those in the above-described embodiment, and their detailed description is omitted.

As shown by phantom lines in FIG. 2D, a heat dissipating member 10 can be also further provided on the phosphor encapsulating layer 9 in the first embodiment.

The heat dissipating member 10 is, for example, formed from a thermally conductive material such as metal and thermally conductive resin into a generally rectangular plate shape extending in the plane direction. The lower surface of the heat dissipating member 10 is in contact with the entire upper surface of the phosphor encapsulating layer 9. The heat dissipating member 10 is, in plane view, disposed so as to include the phosphor encapsulating layer 9 and the heat dissipating member 10 is formed to be larger than the phosphor encapsulating layer 9.

By providing the heat dissipating member 10 in the LED device 7, heat generated from the LED 4 can be dissipated to the heat dissipating member 10 via the phosphor encapsulating layer 9.

As shown in FIG. 2D, the LED 4 can be also encapsulated by a reflective encapsulating layer 19 as a reflective layer instead of the phosphor encapsulating layer 9 in the first embodiment.

The reflective encapsulating layer 19 is formed from a reflective encapsulating resin composition containing a light reflective component and an encapsulating resin, while not containing a phosphor.

The light reflective component is, for example, a white compound. To be specific, an example of the white compound includes white pigment.

Examples of the white pigment include white inorganic pigment and white organic pigment (e.g., dispersing beads etc.). Preferably, white inorganic pigment is used.

Examples of the white inorganic pigment include oxide such as titanium oxide, zinc oxide, and zirconium oxide; carbonate such as white lead (lead carbonate) and calcium carbonate; and clay minerals such as kaolin (kaolinite).

As the white inorganic pigment, preferably, oxide is used, or more preferably, titanium oxide is used.

To be specific, an example of the titanium oxide includes TiO₂ (titanium oxide (IV) and titanium dioxide).

A crystal structure of the titanium oxide is not particularly limited and examples thereof include rutile, brookite (pyromelane), and anatase (octahedrite). Preferably, rutile is used.

A crystal system of the titanium oxide is not particularly limited and examples thereof include a tetragonal system and an orthorhombic system. Preferably, a tetragonal system is used.

The light reflective component is in a particle shape and the shape thereof is not limited. Examples thereof include a sphere shape, a plate shape, and a needle shape. The light reflective component has an average value of the maximum length (in the case of the sphere shape, the average particle size) of, for example, 1 nm or more and 1000 nm or less.

The mixing ratio of the light reflective component with respect to 100 parts by mass of the encapsulating resin is, for example, 0.5 parts by mass or more, or preferably 1.5 parts by mass or more, and, for example, 90 parts by mass or more, or preferably 70 parts by mass or more.

The light reflective component can have vacancy (bubble). The vacancy reflects light emitted from the LED 4 by a border with the encapsulating resin. The shape of the vacancy is, for example, a sphere shape and the vacancy has an average size of, for example, 1 nm or more and 1000 nm or less. The existence proportion of the vacancy with respect to 100 parts by volume of the encapsulating resin, based on volume, is, for example, 3 parts by volume or more, or preferably 5 parts by volume or more, and, for example, 80 parts by volume or less, or preferably 60 parts by volume or less.

The above-described light reflective component is uniformly dispersed and mixed in the encapsulating resin.

The above-described filler can be also further added to the reflective resin composition. That is, the filler can be used in combination with the light reflective component.

The reflective encapsulating layer 19 is formed in the same manner as that in the above-described phosphor encapsulating layer 9 and encapsulates the LED 4.

In the LED device 7, while the LED 4 is encapsulated by the reflective encapsulating layer 19 and the reliability is improved, the light emitted from the LED 4 upwardly and laterally is reflected downwardly by the reflective encapsulating layer 19, so that the luminous efficiency at the lower side can be improved.

As shown by the phantom lines in FIG. 2D, the heat dissipating member 10 can be also further provided on the reflective encapsulating layer 19.

By providing the heat dissipating member 10 in the LED device 7, heat generated from the LED 4 can be dissipated to the heat dissipating member 10 via the reflective encapsulating layer 19.

The LED 4 can be also encapsulated by an encapsulating layer 29 instead of the phosphor encapsulating layer 9 in the first embodiment.

The encapsulating layer 29 is formed from an encapsulating resin composition containing an encapsulating resin, while not containing a phosphor and a light reflective component.

The encapsulating layer 29 is formed in the same manner as that in the above-described phosphor encapsulating layer 9 and encapsulates the LED 4.

In the LED device 7, the LED 4 is encapsulated by the encapsulating layer 29 and the reliability can be improved.

As shown by the phantom lines in FIG. 2D, the heat dissipating member 10 can be also further provided on the encapsulating layer 29.

By providing the heat dissipating member 10 in the LED device 7, heat generated from the LED 4 can be dissipated to the heat dissipating member 10 via the encapsulating layer 29.

### [Second Embodiment]

As shown in FIG. 1B, in the first embodiment, one pair of electrodes 5 are provided with respect to one piece of phosphor-containing board 2. As shown in FIG. 3A, in the second embodiment, plural pairs (to be specific, four pairs) of electrodes 5 can be provided. The plural pairs of electrodes 5 are disposed in alignment at spaced intervals to each other in the plane direction.

The electrode wire 3 includes an input electrode 5a that is electrically connected to each of the electrodes 5. The input electrode 5a is provided at spaced intervals to the left side of the electrode 5 at the left-side end portion.

Although not shown in FIG. 3A, the wire 6 (ref: FIG. 1B) is formed so that one end thereof is continuous to the electrode 5 and the other end thereof is continuous to the input electrode 5a.

A method for producing the LED device 7 using the circuit board 1 is described with reference to FIGS. 3A to 3C.

The method includes a preparing step, a mounting step, and an encapsulating step.

As shown in FIG. 3A, in the preparing step, the circuit board 1 including the electrode wire 3 in the above-described pattern is prepared.

As shown in FIG. 3B, in the mounting step, the plurality of LEDs 4 are flip-chip mounted on the circuit board 1. To be specific, the terminals 8 (ref: FIG. 2C) of the plurality of LEDs 4 are electrically connected to the plural pairs of electrodes 5.

In the encapsulating step, first, the encapsulating layer 29 is laminated below the heat dissipating member 10.

The encapsulating layer 29 is laminated on the lower surface at the central portion of the heat dissipating member 10 so as to expose the lower surface of the circumferential end portion of the heat dissipating member 10.

The encapsulating layer 29 has a thickness of, for example, 100 µm or more, or preferably 400 µm or more, and, for example, 2 mm or less, or preferably 1.2 mm or less.

An input terminal 11 is provided on the lower surface of the heat dissipating member 10. The input terminal 11 is formed at spaced intervals to the outer side of the encapsulating layer 29. A power source that is not shown is electrically connected to the input terminal 11. A solder 13 is provided on the lower surface of the input terminal 11.

Next, as shown in FIG. 3C, the heat dissipating member 10 having the encapsulating layer 29 laminated thereon is pressed with respect to the circuit board 1 mounted with the LEDs 4. In this manner, the plurality of LEDs 4 are collectively embedded and encapsulated by one piece of encapsulating layer 29. The encapsulating layer 29 covers the upper surface of each of the plurality of LEDs 4. In this manner, the heat dissipating member 10 and the plurality of LEDs 4 are disposed with the encapsulating layer 29 therebetween in the thickness direction.

Along with the encapsulation of the plurality of LEDs 4 by the encapsulating layer 29, the solder 13 is brought into contact with the upper surface of the input electrode 5a.

Next, the encapsulating layer 29 and the solder 13 are heated. In this manner, when the encapsulating layer 29 contains a thermosetting resin, the encapsulating layer 29 is cured and the solder 13 is melted, so that the input terminal 11 is electrically connected to the input electrode 5a.

In this manner, the LED device 7 including the circuit board 1, the plurality of LEDs 4, the encapsulating layer 29, and the heat dissipating member 10 is produced.

According to the LED device 7, heat generated from the plurality of LEDs 4 can be dissipated to the heat dissipating member 10 via the encapsulating layer 29.

### [Third Embodiment]

As shown in FIG. 3C, in the second embodiment, the heat dissipating member 10 and the plurality of LEDs 4 are spaced apart from each other in the up-down direction (thickness direction). As shown in FIG. 4C, in the third embodiment, they are brought into contact with each other.

As shown in FIG. 4B, the encapsulating layer 29 is adjusted to have a thickness allowing the encapsulating layer 29 to be excluded from a space between the heat dissipating member 10 and the plurality of LEDs 4 and to be not in contact with the input terminal 11 at the time of pressing the heat dissipating member 10 with respect to the circuit board 1. To be specific, the encapsulating layer 29 has a thickness of, for example, 100 µm or more, or preferably 400 µm or more, and, for example, 2 mm or less, or preferably 1.2 mm or less.

The heat dissipating member 10 on which the encapsulating layer 29 is laminated is pressed with respect to the circuit board 1 mounted with the LEDs 4 so that the encapsulating layer 29 is excluded from a space between the heat dissipating member 10 and the plurality of LEDs 4.

In this manner, the heat dissipating member 10 is in contact with the plurality of LEDs 4.

In the LED device 7, heat generated from the plurality of LEDs 4 can be directly dissipated to the heat dissipating member 10 without through the encapsulating layer 29.

To be more specific, the heat generated from the plurality of LEDs 4 is dissipated upwardly toward the heat dissipating member 10 and light emitted from the LEDs 4 can be applied downwardly via the phosphor-containing board 2. Furthermore, an electric current is input from a power source that is not shown into the LEDs 4 via the input terminal 11, the solder 13, and the electrode wires 3 (the input electrode 5a, the wires 6 (ref: FIG. 1B), and the electrodes 5). That is, the electric current flows laterally. Then, a path of the heat is formed from the LEDs 4 upwardly; a path of the light is formed from the LEDs 4 downwardly; and a path of the electric current is formed laterally with respect to the LEDs 4. Thus, each of the paths of the heat, the light, and the electric current can be separated in three directions. As a result, the design of the LED device 7 can be simplified and the design considering the heat dissipation can be achieved.

### [Fourth Embodiment]

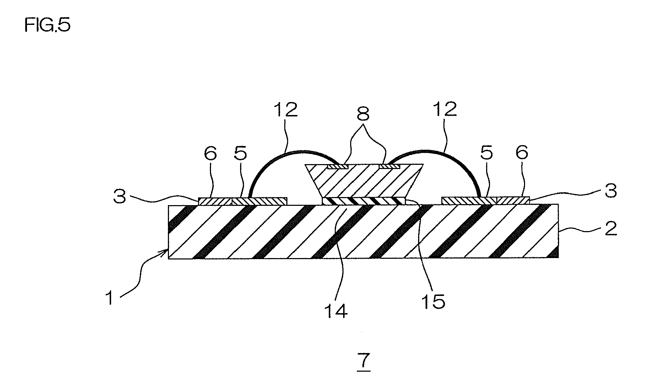

As shown in FIGS. 2C and 2D, in the first embodiment, the terminals 8 are formed on the lower surface of the LED 4 to be electrically connected to the electrodes 5 by the terminals 8, so that the LED 4 is flip-chip mounted on the circuit board 1. As shown in FIG. 5, in the fourth embodiment, the LED 4 is wire-bonding connected to the electrodes 5.

The electrode wires 3 are formed into a pattern ensuring a mounting region 14 in which the LED 4 is mounted in the phosphor-containing board 2. That is, the electrode wires 3 are formed at spaced intervals to the outer sides of the mounting region 14.

In the LED 4, a face-up structure (so-called, face-up chip) for being subjected to wire-bonding connection with respect to the electrodes 5 is used. The LED 4 is, in front view, formed into a generally trapezoidal shape in which the length in the right-left direction gradually increases upwardly. One pair of terminals 8 are formed on the upper surface of the LED 4.

In the LED device 7, the adhesive layer 15 is provided between the LED 4 and the mounting region 14 of the phosphor-containing board 2.

The adhesive layer 15 is made of a light-transmitting or transparent adhesive. Examples of the adhesive include a silicone-based adhesive, an epoxy-based adhesive, an acrylic adhesive, and a paste containing these resins and a filler.

The adhesive layer 15 allows the lower surface of the LED 4 to adhere to the upper surface of the phosphor-containing board 2.

The adhesive layer 15 has a thickness of, for example, 2 µm or more, or preferably 5 µm or more, and, for example, 500 µm or less, or preferably 100 µm or less.

To mount the LED 4 in the circuit board 1, the LED 4 is mounted in the mounting region 14 via the adhesive layer 15 and the terminals 8 are electrically connected to the electrodes 5 via wires 12.

Each of the wires 12 is formed into a linear shape. One end thereof is electrically connected to the terminal 8 of the LED 4 and the other end thereof is electrically connected to the electrode 5.

Examples of a material of the wire 12 include metal materials used as wire bonding materials of the LED 4 such as gold, silver, and copper. Preferably, in view of corrosion resistance, gold is used.

The wire 12 has a wire diameter (thickness) of, for example, 10 µm or more, or preferably 20 µm or more, and, for example, 100 µm or less, or preferably 50 µm or less.

The wire 12 is, in a state of connecting the terminal 8 to the electrode 5, curved or bent to be formed into a generally arc shape (e.g., triangular arc shape, quadrangular arc shape, circular arc shape, etc.).

According to the fourth embodiment, the same function and effect as that of the first embodiment can be achieved.

In the conventional wire-bonding connection, a part of the light emitted from the LED 4 upwardly and laterally is blocked by the wires 12, so that the light emission amount is reduced. However, as shown in FIG. 5, in the fourth embodiment, the light emitted from the LED 4 goes downwardly via the phosphor-containing board 2, so that a reduction in the above-described light emission amount can be surely prevented. Thus, in the wire-bonding connection that is capable of easily achieving the electrical connection to the wire 6, a reduction in the light emission amount of the LED device 7 can be surely prevented.

### [Fifth Embodiment]

As shown in FIG. 5, in the fourth embodiment, the LED 4 is formed into a generally trapezoidal shape in front view. However, the shape of the LED 4 in front view is not particularly limited. As shown in FIG. 6, in the fifth embodiment, the LED 4 can be also formed into, for example, a generally rectangular shape in front view.

According to the fifth embodiment, the same function and effect as that of the fourth embodiment can be achieved.

### [Sixth Embodiment]

As shown in FIGS. 5 and 6, in the fourth and fifth embodiments, the LED 4 (so-called, face-up chip) subjected to the wire-bonding connection is mounted in the circuit board 1. However, the structure (type), the mounting method, and the connecting method of the LED 4 are not particularly limited. As shown in FIG. 7, in the sixth embodiment, the LED 4 (so-called, flip chip, ref: FIGS. 1A, 1B, 2C, 2D, 3A to 3C, and 4A to 4C) subjected to the flip-chip mounting in the first to third embodiments can be also subjected to wire-bonding connection with respect to the circuit board 1.

That is, the LED 4 shown in FIG. 2C is reversed upside down and as shown in FIG. 7, the reversed LED 4 is mounted in the phosphor-containing board 2 via the adhesive layer 15.

Meanwhile, the wires 12 are electrically connected to the terminals 8 of the LED 4.

According to the sixth embodiment, the same function and effect as that of the first embodiment can be achieved.

Meanwhile, as shown in FIG. 2D, in the LED device 7 of the first embodiment, a part of the light emitted from the LED 4 downwardly is blocked by the terminals 8, the electrodes 5, and the wires 6 that are disposed in opposed relation to the lower side of the LED 4, so that the light emission amount is reduced.

Meanwhile, as shown in FIG. 7, in the LED device 7 of the sixth embodiment, the terminals 8 are provided on the upper surface of the LED 4 and the electrode wires 3 are disposed at spaced intervals to the outer sides of the LED 4, so that a reduction in the light emission amount can be surely prevented in the same manner as that in the LED device 7 shown in FIG. 2D.

### [Seventh Embodiment]

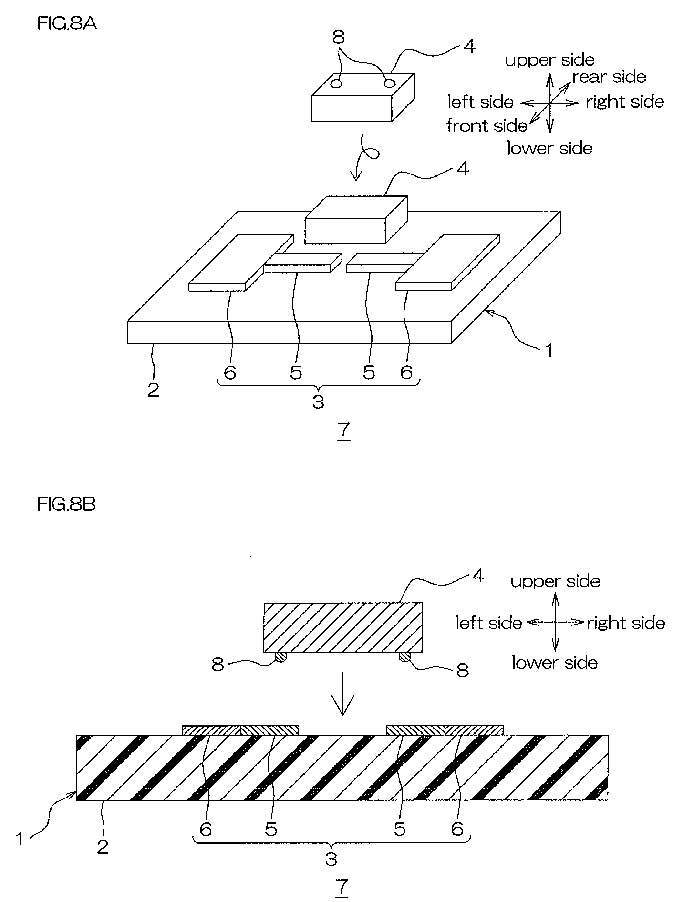

As shown in FIG. 6, in the fifth embodiment, the LED 4, as a face-up chip, is wire-bonding connected to the electrodes 5 with the terminals 8 upwardly. As shown by an arrow in FIG. 8A, in the seventh embodiment, the LED 4 in FIG. 6 is reversed upside down and the terminals 8 face downwardly. Then, as shown by an arrow in FIG. 8B, the LED 4 can be also electrically connected to the wires 6 directly or via a solder that is not shown.

The seventh embodiment shows the LED 4 as the face-up chip shown in FIG. 8A reversed upside down to be mounted on the circuit board 1. The plane area of the terminals 8 in FIG. 8B is designed to be smaller than that of the terminals 8 of the LED 4 as the flip chip in FIG. 2C.

Thus, according to the seventh embodiment, of the light emitted from the LED 4 downwardly, the light amount of the light blocked by the terminals 8 can be more suppressed than the LED 4 of the first embodiment in FIG. 2D.

### [Modified Example]

In the above-described embodiments, the LED 4 and the LED device 7 are described as one example of the optical semiconductor element and the optical semiconductor device of the present invention, respectively. Alternatively, for example, an LD (laser diode) 4 and a laser diode device 7 can also serve as the optical semiconductor element and the optical semiconductor device of the present invention, respectively.

While the illustrative embodiments of the present invention are provided in the above description, such is for illustrative purpose only and it is not to be construed as limiting the scope of the present invention. Modification and variation of the present invention that will be obvious to those skilled in the art is to be covered by the following claims.

### Industrial Applicability

The circuit board is used in the optical semiconductor device.

### Description of Reference Numerals

- 1: Circuit board
- 2: Phosphor-containing board
- 3: Electrode wire
- 4: LED
- 7: LED device
- 9: Phosphor encapsulating layer
- 10: Heat dissipating member
- 19: Reflective encapsulating layer
- 29: Encapsulating layer

## Claims

1. A circuit board comprising:
a phosphor-containing board for mounting an optical semiconductor element at one side thereof in a thickness direction and
an electrode wire laminated at the one side in the thickness direction of the phosphor-containing board so as to be electrically connected to the optical semiconductor element.

2. The circuit board according to claim 1, wherein
the phosphor-containing board has light-transmitting properties.

3. The circuit board according to claim 1, wherein
the phosphor-containing board is prepared from ceramics.

4. The circuit board according to claim 1, wherein
the phosphor-containing board is prepared from a phosphor resin composition in a C-stage state containing a phosphor and a curable resin.

5. An optical semiconductor device comprising:
a circuit board including:
a phosphor-containing board for mounting an optical semiconductor element at one side thereof in a thickness direction and
an electrode wire laminated at the one side in the thickness direction of the phosphor-containing board so as to be electrically connected to the optical semiconductor element and
the optical semiconductor element mounted at the one side in the thickness direction of the phosphor-containing board of the circuit board so as to be electrically connected to the electrode wire.

6. The optical semiconductor device according to claim 5 further comprising:
at least any one of an encapsulating layer, a reflective layer, and a phosphor layer provided at the one side in the thickness direction of the phosphor-containing board.

7. A method for producing an optical semiconductor device comprising:
a preparing step of preparing a circuit board including:
a phosphor-containing board for mounting an optical semiconductor element at one side thereof in a thickness direction and
an electrode wire laminated at the one side in the thickness direction of the phosphor-containing board so as to be electrically connected to the optical semiconductor element and
a mounting step of mounting the optical semiconductor element at the one side in the thickness direction of the phosphor-containing board of the circuit board so as to be electrically connected to the electrode wire.
